# EUROPÄISCHE PATENTSCHRIFT

(11) **EP 3 166 214 B1**
(45) Veröffentlichungstag und Bekanntmachung des Hinweises auf die Patenterteilung: **12.12.2018**
(21) Anmeldenummer: 16194705.6
(22) Anmeldetag: 20.10.2016
(51) Int. Cl.: H02K 5/22, H02K 5/10, H02K 11/30

(54) **ELEKTRONIKEINHEIT FÜR EINEN ELEKTROMOTOR**
ELECTRONICS UNIT FOR AN ELECTRICAL MOTOR
UNITÉ D'ÉLECTRONIQUE POUR UN MOTEUR ÉLECTRIQUE

(30) Priorität: 05.11.2015 DE 102015119002
(43) Veröffentlichungstag der Anmeldung: 10.05.2017
(73) Patentinhaber: ebm-papst Mulfingen GmbH & Co. KG, 74673 Mulfingen (DE)
(72) Erfinder: STURM, Michael, 97980 Bad Mergentheim-Rot (DE); SAUER, Thomas, 97980 Bad Mergentheim (DE); MASCHKE, Matthias, 74635 Kupferzell (DE)
(74) Vertreter: Staeger & Sperling Partnerschaftsgesellschaft mbB

(56) Entgegenhaltungen:
- EP-A1- 2 750 266
- EP-A2- 1 133 012
- DE-A1-102012 204 145
- DE-U1-202009 007 044
- JP-A- 2009 211 992
- US-A1- 2006 113 852

## Beschreibung

Die vorliegende Erfindung betrifft eine Elektronikeinheit, sowie einen Elektromotor mit einer solchen Elektronikeinheit. Darüber hinaus betrifft die Erfindung auch bestimmte, erfindungswesentliche Komponenten (z.B. als Ersatzteil) des Elektromotors und/oder der Elektronikeinheit.

Die seit Jahrzehnten international genormte IP-Schutzart gibt die Eignung von elektrischen Betriebsmitteln für verschiedene definierte Umgebungsbedingungen an, den Schutz von Personen gegen potentielle Gefährdung durch einen Stromschlag bei deren Benutzung zu gewährleisten.

Bei vielen elektrischen Applikationen müssen elektrische und elektronische Geräte unter erschwerten Umweltbedingungen über viele Jahre sicher und zuverlässig funktionieren. Außer dem zulässigen Temperaturbereich stellt die korrosive Belastung, hierunter wird die Beständigkeit gegen aggressive Medien in der Industrie wie Feuchte, Wasser, Dämpfe, Säuren, Laugen, Öl oder Kraftstoffe verstanden, eine Einsatzbeschränkung dar.

Darüber hinaus muss auch das Berühren bzw. das Eindringen von Fremdkörpern und von Staub, sowie die Kontamination mit Bakterien und Viren (in der Medizintechnik), oder die mechanische Beanspruchung durch Stoßeinwirkung für eine zuverlässige Funktion und sicheren Gebrauch verhindert werden.

In der IEC/EN 60529 sind die IP-Schutzarten normativ definiert. Den in der Schutzartbezeichnung immer vorhandenen Buchstaben IP werden zwei Kennziffern angehängt. Diese zeigen an, welchen Schutzumfang ein Gehäuse bezüglich Berührung bzw. Fremdkörper (erste Kennziffer) und Feuchtigkeit bzw. Wasser (zweite Kennziffer) bietet

Der internationale Standard EN 60034-Teil 5 bzw. die Konkordanz VDE 0530-5 gilt für die Einteilung der Schutzarten drehender elektrischer Maschinen durch ein Gehäuse. Sie legt die Anforderungen an die Gehäuse fest, die in jeder anderen Hinsicht für ihre beabsichtigte Verwendung geeignet sind und die hinsichtlich der Werkstoffe und Verarbeitung sicherstellen, dass die in dieser Norm angegebenen Eigenschaften bei bestimmungsgemäßer Anwendung erhalten bleiben.,

Ein gattungsgemäßer Elektromotor ist in der DE 103 13 274 A1 beschrieben. Es handelt sich dabei speziell um einen Motor mit einem im Wesentlichen geschlossenen bzw. Schutzart-gekapselten Motorgehäuse. Der Elektromotor bestehend aus einem Stator und einem den Stator von einer Seite her als Teil eines Motorgehäuses topfartig umschließenden Außenläufer sowie einem sich als weiterer Teil des Motorgehäuses auf der dem Außenläufer axial gegenüberliegenden Seite anschließenden, eine Steuerelektronik enthaltenden Elektronikgehäuse. Das Motorgehäuse ist im Wesentlichen geschlossen bzw. gekapselt ausgeführt.

Bei diesem Elektromotor weist das Elektronikgehäuse eine Öffnung zum elektrischen Anschluss auf, wobei diese Öffnung mit einem mit äußeren Anschlussleitungen verbundenen Anschlusssteckverbinder dicht verschließbar ist. Allerdings war es bei solchen bekannten Motoren bisher stets so, dass für alle inneren Verbindungen fest angeschlossene, insbesondere verlötete Leitungen vorgesehen waren. So auch in der EP 2 226 922 A1.

Die Druckschriften JP 2009 211992 A, EP 1 133 012 A2 und die US 2006/113852 A1 beschäftigen sich mit Gehäusen zu Elektronikeinheiten. Aus der DE 20 2009 007044 U1 ist eine Elektronikeinheit für einen Elektromotor bekannt, bei der das Elektronikgehäuse abgedichtet ist.

Nachteilig ist dass solche Ausführungen bekanntermaßen eine nicht dauerhaft zuverlässige Dichtigkeit aufweisen und unter bestimmten Betriebsbedingungen Feuchtigkeit in das Motorgehäuse eindringen kann, was zu vermeiden gilt.

In der EP 2 043 234 A1 ist hierzu eine Lösung gezeigt, bei der das Elektronikgehäuse über entsprechende Dichtebenen und Dichtmittel abgedichtet ist. Dazu ist vorgesehen, dass alle inneren elektrischen Verbindungen zwischen der Anschlusseinrichtung und der Steuerelektronik und/oder zwischen der Steuerelektronik und der Stator-Verschaltungsanordnung als Steckverbindungen ausgebildet sind, die bezüglich ihrer Steck- und Löserichtung vorzugsweise entsprechend einer Motorachse bzw. dazu achsparallel ausgerichtet sind, wobei die Steckverbindungen zwischen der Steuerelektronik und der Stator-Verschaltungseinrichtung eine Trennwand eines Statorflansches abgedichtet durchgreifen.

Ferner wird eine Anschlusseinrichtung, die einen Zwischenträger als Klemmkasten aufweist, vorgesehen, welcher Anschlusskontakte für die äußeren Anschlussleitungen sowie Kontaktelemente der Steckverbindungen zur Steuerelektronik hin trägt, wobei der Zwischenträger im Bereich von Kontakt-Durchfuhröffnungen der Wandung des Elektronikgehäuses mehrere Dichtungen zur dichtenden Anlage an der Wandung des Elektronikgehäuses aufweist. Der Klemmkasten wird mit Flachstecker bestückt und in eine im Gehäuse ausgebildete Klemmkastenaufnahme eingesetzt. Bauartbedingt, sind daher mit Nachteil mehrere in Axialrichtung vorhandene Dichtbereiche in unterschiedlichen Dichtebenen vorhanden.

Wünschenswert ist es daher, eine Reihe von den daraus resultierenden Nachteilen zu vermeiden. Da jede Dichtung mit applikationsspezifischen Dichtheitsproblemen behaftet ist, ist es vorteilhaft die Anzahl der Dichtungen generell zu reduzieren. Ferner sind bei der Abstimmung diverser Zusammenbaukomponenten und Bauteile einer Elektronikeinheit auch die Toleranzen und daraus resultierenden Toleranzketten nur mit hohem Aufwand zu beherrschen. Es ist erforderlich, insbesondere bei mehreren in Axialrichtung vorhandener Dichtebenen, die Toleranzen der zur Dichtung beitragender Bauteile und die Konfiguration der Dichtungen exakt aufeinander abzustimmen.

Darüber hinaus, ist eine Dichtung zur Leiterplatte und damit zur Steuerelektronik nicht gegeben, solange oder sobald der Klemmkasten nicht montiert bzw. demontiert ist.

Es ist ferner wünschenswert die Anzahl der Steckverbindungen und demnach die Anzahl der Kontaktübergänge zu reduzieren. Mit jedem Kontaktübergang ist ein Übergangswiderstand und damit Wärmeentwicklung verbunden. Bei der zuvor genannten Lösung ist es ferner nachteilhaft, dass das Risiko der Kontaktbeschädigung auftritt. So kann es vorkommen dass die Steckerpins (Signalkontakte) als auch die Netzanschlusskontakte beim Transport, der Montage und/oder z. B. beim Handling der Anschlußverdrahtung verbogen oder beschädigt werden. Es ist daher auch eine bestimmte Montageabfolge beim "blinden" Fügen beim Zusammenbau der Bauteile notwendig.

Weiter nachteilig bei der im Stand der Technik bekannten Lösungen sind deren hohe Bauteilanzahl und deren komplexer Aufbau.

Es ist daher Aufgabe der vorliegenden Erfindung vorbesagte Nachteile zu überwinden und eine verbesserte und insbesondere bauteiloptimierte Lösung für eine gedichtete Elektronikeinheit mit einer gedichteten Schnittstelle bzw. einen Elektromotor mit einer solchen Elektronikeinheit bereitzustellen.

Diese Aufgabe wird durch die Merkmalskombination gemäß Patentanspruch 1 bzw. durch Patentanspruch 11 gelöst.

Ein Grundgedanke der vorliegenden Erfindung liegt darin, dass eine auf einer Leiterplatte angeordnete Schnittstellenbaugruppe vorgesehen wird, die einerseits in ihrem Schnittstellenbereich und andererseits gegenüber dem die Leiterplatte umgebenden Elektronikgehäuse abgedichtet ist, so dass das Innere des Elektronikgehäuses auch im nicht eingesetzten Zustand einer Anschlussbox gegen Eintritt einer Flüssigkeit abgedichtet wird. Hierzu wird erfindungsgemäß ferner die Anzahl der Kontaktübergänge reduziert, wodurch die Dichtungsebene in den Bereich der Wandung zwischen dem Elektronikgehäuse und dem Schnittstellenbereich angeordnet werden kann. Auf diese Weise können die im Stand der Technik verwendeten, in der Anschlussbox integrierten Anschlusssockel entfallen, wodurch die Teileanzahl weiter reduziert wird.
Darüber hinaus können dadurch die Anschlusssteckverbinder bequem außerhalb der Anschlussbox konfektioniert und dann unmittelbar auf die entsprechenden Kontakte der Schnittstellenbaugruppe gesteckt werden. Erfindungsgemäß wird daher eine Elektronikeinheit für einen Elektromotor bereitgestellt, die mit einem Elektronikgehäuse ausgebildet ist, in dem eine, auf einer Leiterplatte angeordnete Steuerelektronik angeordnet ist, auf der eine Schnittstellenbaugruppe mit einer Kontakte aufweisenden Steckerschnittstelle zum Einstecken wenigstens eines Anschlusssteckverbinders befestigt ist, wobei das Elektronikgehäuse einen Aufnahmebereich aufweist, in den bestimmungsgemäß eine Anschlussbox zum Anschluss des oder der Anschlusssteckverbinder einsetzbar ist. Erfindungsgemäß ist ferner mittels einer Dichtungsanordnung die Schnittstellenbaugruppe stirnseitig im Bereich der Steckerschnittstelle abdichtet, wobei eine Dichtung der Dichtungsanordnung das Innere des Elektronikgehäuses abdichtet, derart, dass das Innere des Elektronikgehäuses auch bei nicht montierter oder eingesetzter Anschlussbox gegen Eintritt einer Flüssigkeit abgedichtet wird.

In einer bevorzugten Ausführungsform ist vorgesehen, dass der Aufnahmebereich für die Anschlussbox oberhalb der Steckerschnittstelle, vorzugsweise oberhalb einer in einer Wandung des Elektronikgehäuses ausgebildeten Öffnung angeordnet ist.

Erfindungsgemäß ist vorgesehen dass die Schnittstellenbaugruppe ein Kontaktträgergehäuse mit einer Gehäusewandung aufweist, an der entlang einem Stirnseitenabschnitt dieser Gehäusewandung, die als umlaufende Dichtung ausgebildete Dichtung angebracht ist, die gegen eine innere Dichtfläche im Elektronikgehäuse dichtend anliegt. Mit Vorteil ist weiter vorgesehen, dass die Schnittstellenbaugruppe ein Kontaktträgergehäuse aufweist, an dem Halteelemente, vorzugsweise integral mit dem Kontaktträgergehäuse ausgebildet sind, an oder mittels denen die Schnittstellenbaugruppe auf der Leiterplatte befestigt ist. Weiter bevorzugt ist es neben z. B. in die Leiterplatte einsteckbaren Rastarmen auch Indexierungsdome vorzusehen, die mit entsprechenden Indexierungsöffnungen auf der Leiterplatte zusammenpassen. Ferner können mit Vorteil am Kontaktträgergehäuse auch Gehäuseabschnitte mit Öffnungen vorgesehen werden zur Verschraubung mit entsprechenden Befestigungslöchern in der Leiterplatte. In einer ebenfalls vorteilhaften Ausgestaltung der Erfindung weisen die Kontakte der Schnittstellenbaugruppe ein Leiterplattenanschlussende auf, die z. B. als Lötkontaktenden oder als Einpressbereiche ausgebildet sind.

Erfindungsgemäß ist vorgesehen, dass das Elektronikgehäuse im Aufnahmebereich für die Anschlussbox eine in Axialrichtung abgestufte Wandung mit einem gegenüber einem ersten Wandungsbereich erhöhten Auflagenbereich für die Anschlussbox ausbildet, wobei die umlaufende Dichtung der Dichtungsanordnung gegen eine Innenseite des Elektronikgehäuses im erhöhten Auflagenbereich der Wandung des Elektronikgehäuses anliegt.
Es ist weiter von Vorteil, wenn eine im Bereich der Steckerschnittstelle angeordnete, vorzugsweise als Teil der der Dichtungsanordnung die Kontakte der Schnittstellenbaugruppe zumindest teilweise umschließt und an diesen unmittelbar anliegt.

Bevorzugt besteht demnach die Dichtungsanordnung aus einer ersten und zweiten Dichtung, bei der die eine Dichtung als Dichtung gegenüber einer Wandung des Elektronikgehäuses anliegt und eine zweite Dichtung die Schnittstellenstirnseite abdichtet.

In einer weiteren vorteilhaften Ausgestaltung der Erfindung ist vorgesehen, dass die Anschlussbox einen Aufnahmeraum und wenigstens einen, vorzugsweise einstückig mit der Anschlussbox ausgebildeten Kabeldurchlass (z. B. eine Kabelverschraubung) für wenigstens einen mit einem Anschlusskabel versehenen Anschlusssteckverbinder aufweist, sowie einen mit wenigstens einer Montageöffnung ausgebildeten Boden, durch die ein Anschlusssteckverbinder zur, vorzugsweise in der Anschlussbox ein- oder verrastenden Kontaktierung mit der Schnittstellenbaugruppe hindurch gesteckt bzw. montiert werden kann. Besonders vorteilhaft ist daher eine Rastgeometrie in der Anschlussbox vorzusehen, die mit einer Gegenrastgeometrie am Steckverbinder zusammenwirkt.

Alternativ kann auch eine Rastgeometrie zum Verrasten des Steckverbinders unmittelbar am Gehäuse der Schnittstellenbaugruppe angebracht sein.

Weiter vorteilhaft ist es, wenn die Anschlussbox ferner einen über ein Dichtmittel abgedichteten, demontierbaren Deckel aufweist, der vorzugsweise mit einem integrierten aktiven oder passiven Element wie z.B. einem Lichtwellenleiter und/oder mit einer integrierten Antenne ausgestattet ist.

Erfindungsgemäß ist vorgesehen, wenn das Elektronikgehäuse oberhalb des Aufnahmeraums für die Anschlussbox mit einem demontierbaren Deckel versehen ist, vorzugsweise mit integrierter Antenne und weiter vorzugsweise mit einer Statusmeldeanzeige.

In einer ebenfalls vorteilhaften Ausgestaltung der Erfindung ist vorgesehen, dass der Boden der Anschlussbox eine zur abgestuften Wandung korrespondierende Kontur aufweist.

Zum Schutz der Kontakte wird in erfindungsgemäßer Weise, wegen der Integration der Kontakte in die Schnittstellenbaugruppe vorgesehen, dass im Kontaktträgergehäuse der Schnittstellenbaugruppe eine die Kontakte umgebende Gehäusewandung vorgesehen ist, die mit ihrer Stirnseite gegenüber den steckseitigen Enden der Kontakte in Axialrichtung hervorsteht.

Darüber hinaus kann vorgesehen werden, dass in der Schnittstellenbaugruppe ferner eine Antenne und/oder eine NFC-Drossel und/oder ein Lichtwellenleiter angeordnet bzw. abgedichtet integriert sind.

In einer bevorzugten Ausgestaltung ist das Elektronikgehäuse als topfförmiges Gehäuse mit einem umlaufenden ringförmigen Gehäuseflansch ausgebildet, wobei ferner die Ausnehmung für die Anschlussbox als seitlich offene Vertiefung im topfförmigen Gehäuse angeordnet ist.

Ein weiterer Aspekt der vorliegenden Erfindung betrifft einen Elektromotor, vorzugsweise ein Aussenläufermotor mit einer wie zuvor beschriebenen erfindungsgemäßen Elektronikeinheit.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt.

Es zeigen:
- Fig. 1: eine isometrische Explosionsansicht eines Ausführungsbeispiels einer Elektronikeinheit,
- Fig. 2: eine isometrische Explosionsansicht der Elektronikeinheit ähnlich der Figur 1, wobei ein anderer Zusammenbauzustand abgebildet ist,
- Fig. 3: eine isometrische Ansicht von unten und oben auf die erfindungsgemäße Schnittstellenbaugruppe ,
- Fig. 4: eine perspektivische Aufsicht auf das Elektronikgehäuse ohne montierte Anschlussbox und
- Fig. 5: eine Schnittansicht durch einen Teil der Elektronikeinheit.

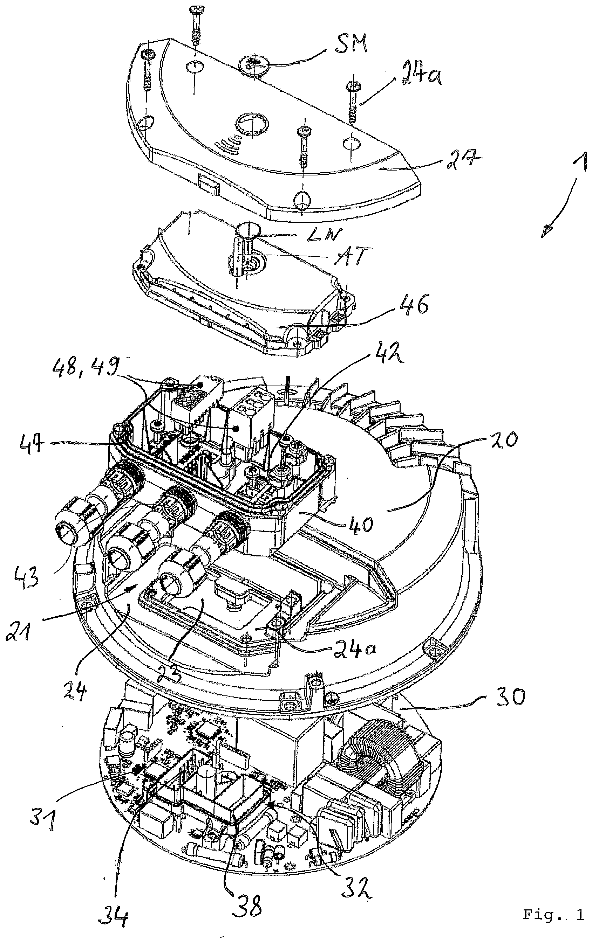

Im Folgenden wird die Erfindung mit Bezug auf die Figuren 1 bis 5 anhand eines Ausführungsbeispiels näher beschrieben, wobei gleiche Bezugszeichen in den Figuren auf die gleichen funktionalen und/oder strukturellen Merkmale hinweisen.

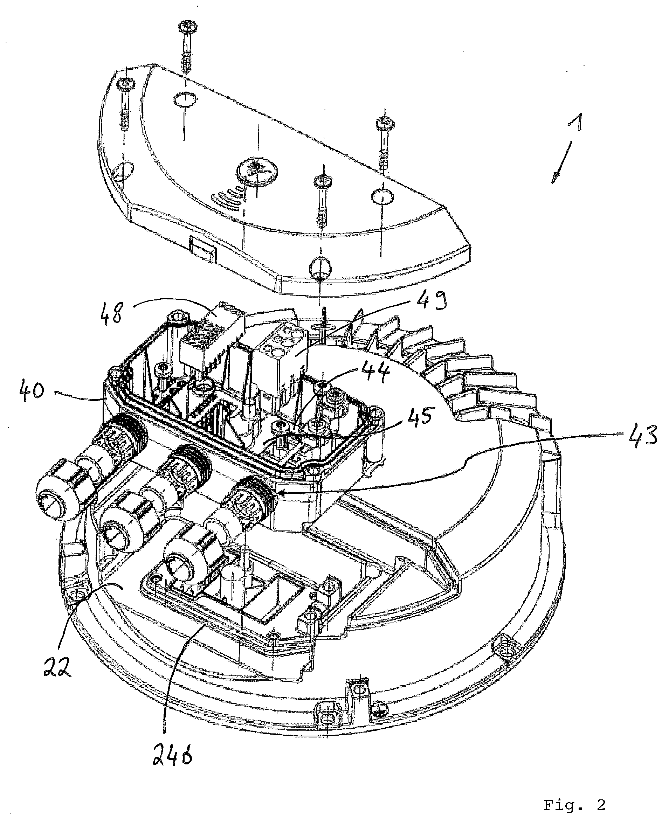

In den Figuren 1 und 2 sind isometrische Explosionsansichten eines Ausführungsbeispiels einer erfindungsgemäßen Elektronikeinheit 1 gezeigt. Die Elektronikeinheit 1 umfasst eine Leiterplatte 30, ein Elektronikgehäuse 20 und eine Anschlussbox 40, die im Folgenden näher beschrieben werden.

### Das Elektronikgehäuse 20

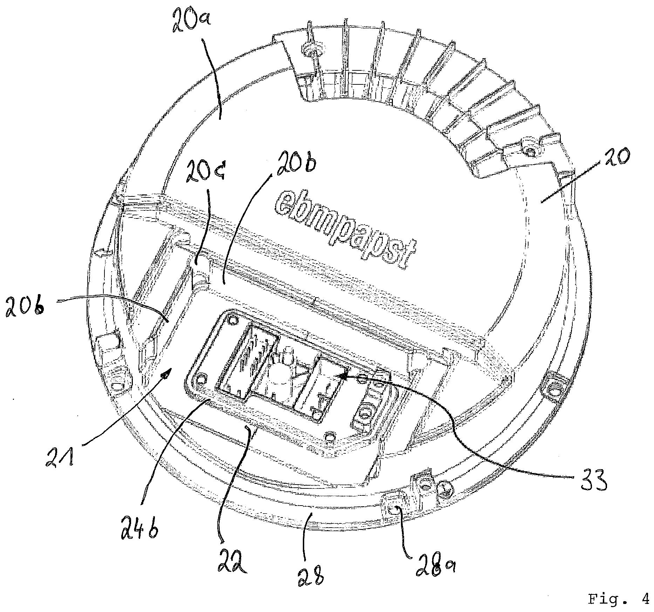

Wie in der Fig. 4 zu erkennen ist weist das Elektronikgehäuse 20 eine topfartige Form auf, wobei außen umlaufend ein Gehäuseflansch 28 mit Befestigungsöffnungen 28a vorgesehen ist. Wie weiter in der Fig. 4 zu erkennen ist, ist in dem topfförmigen Elektronikgehäuse 20 ein Aufnahmeraum 21 vorgesehen, welcher als Gehäusevertiefung und als ein nach außen offener Aufnahmeraum 21 ausgebildet ist, in den sich eine noch später näher beschriebene Anschlussbox 40 einsetzen und montieren lässt. Im Aufnahmeraum 21 ist eine im Wesentlichen parallel zur Deckelfläche 20a verlaufende Wandung 22 vorgesehen. In der Wandung 22 ist eine Öffnung 23 vorgesehen, durch die hindurch die Schnittstellenbaugruppe 32, welche auf der Leiterplatte 30 montiert ist, zugänglich ist. Im Bereich des Aufnahmeraums 21 befindet sich ein erster Wandungsbereich 24 (siehe Figur 1) sowie ein gegenüber dem ersten Wandungsbereich 24 erhöhter Auflagenbereich 24a, der gegenüber dem ersten Wandungsbereich 24 durch zwei Stufen 24b (siehe Figur 2 und 4) gegenüber dem ersten Wandungsbereich 24 erhöht ist. Die zuvor genannte Öffnung 23 befindet sich innerhalb des erhöhten Auflagebereichs 24a. Wie ferner in der Fig. 2 und der Fig. 4 deutlich zu erkennen ist, laufen die Stufen 24b um den erhöhten Auflagenbereich 24a herum und umschließen damit die Öffnung 23. Die Innenseite 25 im Bereich der Stufen 24b und des erhöhten Auflagenbereichs 24a stellt eine Anlagefläche für die Dichtung 36, die in der Figur 6 näher zu erkennen ist, der Schnittstellenbaugruppe 32 bereit. Anders ausgedrückt bedeutet dies, dass die Dichtung 36, welche an der Schnittstellenbaugruppe 32 stirnseitig vorgesehen ist, gegen eine entsprechend korrespondierende Anlagefläche auf der Innenseite 25 des Elektronikgehäuses 20 anliegt Der Aufnahmeraum 21 wird an drei Seiten durch stufenartige Wandungen 20b begrenzt, entlang denen sich zylinderförmige Aussparungen 20c zur Vorzentrierung der Anschlussbox 40 an entsprechend ausgebildeten Eckbereichen der Anschlussbox 40 befinden.

### Die Schnittstellenbaugruppe 32

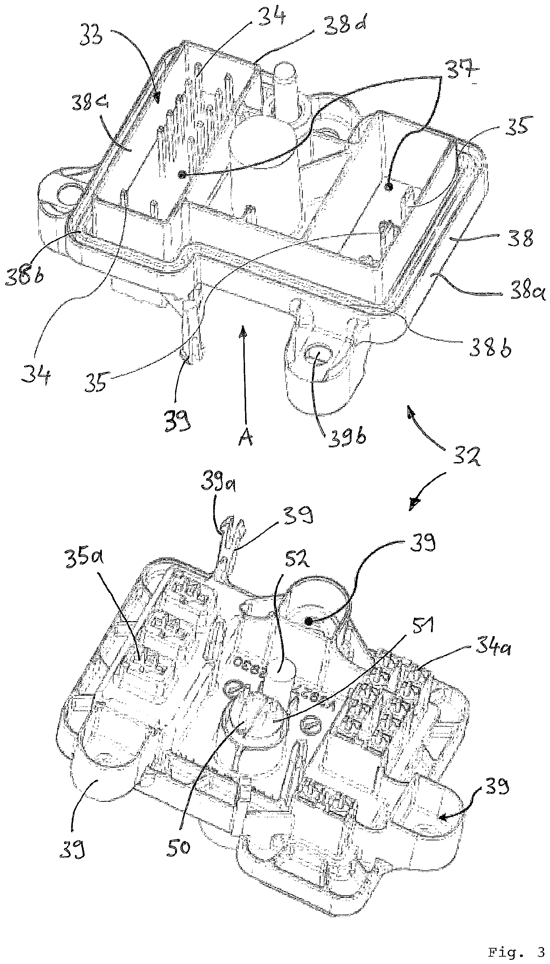

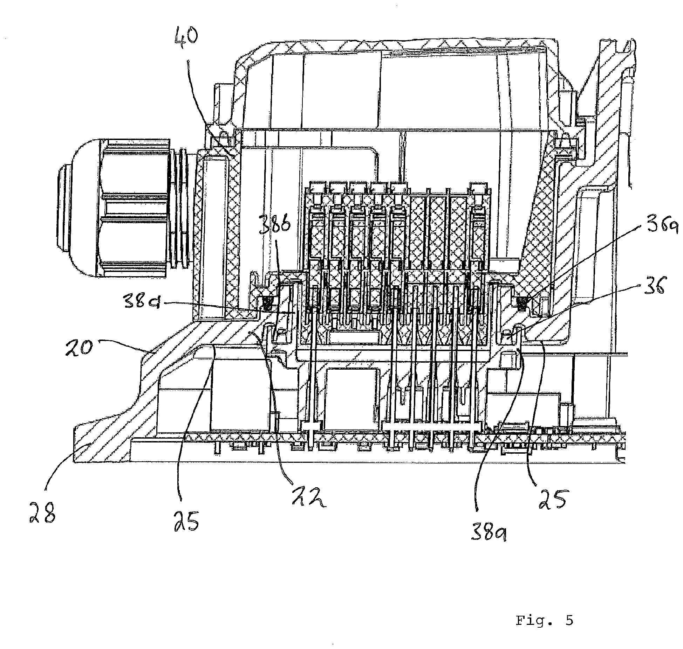

In der Fig. 3 ist eine erfindungsgemäße Schnittstellenbaugruppe 32 in einer Ober- und Unteransicht dargestellt. Die Schnittstellenbaugruppe 32 wird auf der Leiterplatte 30 zusammen mit einer Steuerelektronik 31 angeordnet. Die Schnittstellenbaugruppe 32 weist ein Kontaktträgergehäuse 38 auf, in dem Kontakte 34, 35 (Signal- und Power-Kontakte) angeordnet sind. Wie in der unteren Ansicht der Fig. 3 ersichtlich, weisen die Kontakte 34, 35 Kontaktanschlussenden 34a, 35a zur Leiterplattenmontage auf. Das Kontaktträgergehäuse 38 besitzt eine Gehäusewandung 38a mit einem Stirnseitenabschnitt 38b der vorliegend kanalförmig ausgebildet ist und zur Aufnahme einer Dichtung 36, wie diese in Fig. 5 dargestellt ist. Ferner ist eine zweite Gehäusewandung 38c um die Kontakte 34, 35 herum vorgesehen, deren Stirnseite 38d über die Kontaktenden der Kontakte 34 bzw. 35 hinaus vorsteht, sodass ein Kontaktschutz gegen Umbiegen der Kontakte bereitgestellt ist. Die Kontakte sind im Bereich der Steckerschnittstelle 33 von einer Dichtung 37, und zwar einer Vergussmasse umgeben, sodass die Steckerschnittstelle 33 stirnseitig abgedichtet ist. Wie ferner in der Fig. 3 ersichtlich, weist die Schnittstellenbaugruppe 32 Halteelement 39 auf, die vorliegend mit einem Rasthakenabschnitt 39a ausgebildet sind, um die Schnittstellenbaugruppe 32 verrastend auf bzw. an der Leiterplatte 30 zu befestigen. Darüber hinaus sind weitere Halteelemente 39 mit Öffnungen 39b vorgesehen zur weiteren Befestigungsmöglichkeit der Schnittstellenbaugruppe 32 auf der Leiterplatte 30.

In dem vorliegenden Ausführungsbeispiel weist die Schnittstellenbaugruppe 32 ferner eine Antenne 50 und zwar in Form einer NFC-Drossel 51 auf, sowie einen Lichtwellenleiter 52. Sobald das Elektronikgehäuse 20 in seiner bestimmungsgemäßen Position gegenüber der Leiterplatte 30 ist, liegt die Dichtung 36 gegen die Innenseite 25 des Elektronikgehäuses 20 an und dichtet das Innere des Elektronikgehäuses 20 bestimmungsgemäß ab. Da ferner die Steckerschnittstelle 33 mittels dem zuvor genannten Dichtmittel 37, d.h. der Vergussmasse 37, abgedichtet ist, ist somit auch im nicht montierten Zustand der Anschlussbox 40 eine Dichtigkeit gegen Eintritt einer Flüssigkeit vorhanden. Vorzugsweise sind die Dichtungen 36, 37 so ausgestaltet, dass eine Abdichtung gegen Feuchtigkeit / Staub gemäß der internationalen IP-Schutzart nach IP X4 bzw. IP X5 oder höher gewährleistet wird.

Hierzu ist es besonders vorteilhaft, wenn die Dichtung 36 als eine Weichkomponentendichtung ausgebildet ist.

### Die Anschlussbox 40

Ein weiterer Bestandteil der in den Figuren 1 bis 5 dargestellten Elektronikeinheit 1 ist die Anschlussbox 40. Die demontierbare Anschlussbox 40 ist bestimmungsgemäß in ihrer Form so ausgebildet, dass sie sich korrespondierend in den Aufnahmeraum 21 des Elektronikgehäuses 20 montieren lässt und bevorzugt mit dem Elektronikgehäuse 20 mittels Befestigungsmittel verbinden lässt. Die Anschlussbox 40 dient der Aufnahme der Anschlusssteckverbinder 48, 49, die bestimmungsgemäß vorgesehen sind, die Kontakte 34, 35 der Schnittstellenbaugruppe 32 zu kontaktieren bzw. in die Schnittstellenbaugruppe 32 eingesteckt zu werden. Hierzu weist die Anschlussbox 40 einen Aufnahmeraum 42 auf, in dem die Anschlusssteckverbinder 48, 49 Platz finden. Seitlich weist die Anschlussbox 40 in dem vorliegenden Ausführungsbeispiel drei Kabeldurchlässe 43 mit Kabelverschraubungen auf, durch die jeweils ein Anschlusskabel in die Box hineingeführt werden kann, um mit den Anschlusssteckverbindern 48, 49 verbunden zu werden. Nachdem die Anschlusssteckverbinder 48, 49 mit Vorteil außerhalb des Aufnahmeraums 42 der Anschlussbox 40 angeschlossen bzw. konfektioniert wurden, können diese bei montierter Anschlussbox 40 in ihrer bestimmungsgemäßen Position im Aufnahmeraum 21 des Elektronikgehäuses 20 in die Schnittstellenbaugruppe 32 eingesteckt werden. Hierzu weist der Boden 44 der Anschlussbox 40 eine Montageöffnung 45 auf, durch die hindurch die Montage der Anschlusssteckverbinder 48, 49 möglich ist. Ferner weist die Anschlussbox 40 einen demontierbaren Deckel 46 auf, der die Anschlussbox 40 über eine Dichtung 47 dicht verschließt. Hierzu kann der Deckel 47 an den Befestigungspunkten der Anschlussbox 40 verschraubt werden. Im vorliegenden Ausführungsbeispiel weist der Deckel 47 eine integrierte Antenne AT und einen integrierten Lichtwellenleiter LW auf, sodass eine Übertragung des Lichtsignals der Statusmelde-LED über den integrierten gedichteten Lichtwellenleiter ermöglicht wird. Zum Senden und Empfangen von Funksignalen oder zur Funkprogrammierung über die Near-Field-Communication-Methode ist eine Drosselantenne AT im Deckel 46 integriert. Oberhalb des Deckels 46 der Anschlussbox 40 befindet sich ein Gehäusedeckel 27 des Elektronikgehäuses 20, welcher die Anschlussbox 40 im eingebauten Zustand abdeckt. In der vorliegenden Ausführungsform lässt sich der Gehäusedeckel 27 mit dem Deckel 46 der Anschlussbox 40 verrasten und gemeinsam mit diesem an Montageöffnungen an der Anschlussbox 40 mittels Schrauben 27a befestigen.

In der Fig. 5 ist eine Schnittansicht durch einen Teil der Elektronikeinheit 1 gezeigt Gut zu erkennen sind die Dichtebenen und Dichtungen 36, 37 und 47. Ferner ist zu erkennen, dass die Dichtung 36 in dem zuvor genannten kanalförmig ausgebildeten Stirnseitenabschnitt 38b der Gehäusewandung 38a angeordnet ist und gegen eine Innenseite 25 des Elektronikgehäuses 20 im Bereich des Aufnahmeraums 21 dichtend anliegt.

Mit Hilfe der Figuren ist ferner ersichtlich, dass mittels der vorliegenden Erfindung ein vorteilhafter Fügeprozess und eine montagefreundliche Anschlussmöglichkeit der Elektronikeinheit 1 gegeben ist. Aufgrund der speziellen Schnittstellenausführung der Schnittstellenbaugruppe 32 ist ferner eine breite Skalierbarkeit der Kontaktbelegung möglich und lassen sich insbesondere applikationsspezifische Anordnungen von Signal- und Power-Kontakten und demnach spezifische Schnittstellenkonfigurationen realisieren.

## Patentansprüche

1. Elektronikeinheit (1) für einen Elektromotor, die mit einem Elektronikgehäuse (20) ausgebildet ist, in der eine, auf einer Leiterplatte (30) angeordnete Steuerelektronik (31) angeordnet ist, auf der eine Schnittstellenbaugruppe (32) mit einer Kontakte (34, 35) aufweisenden Steckerschnittstelle (33) zum Einstecken wenigstens eines Anschlusssteckverbinders (48, 49) befestigt ist, wobei das Elektronikgehäuse (20) einen Aufnahmebereich (21) aufweist, in den bestimmungsgemäß eine Anschlussbox (40) zum Anschluss des oder der Anschlusssteckverbinder (48, 49) einsetzbar ist,wobei ferner wenigstens eine Dichtungsanordnung vorgesehen ist, die die Schnittstellenbaugruppe (32) stirnseitig im Bereich der Steckerschnittstelle (33) abdichtet und eine Dichtung (36) aufweist, die das Innere des Elektronikgehäuses (20) abdichtet, derart, dass das Innere des Elektronikgehäuses (20) auch im nicht eingesetzten Zustand der Anschlussbox (40) gegen Eintritt einer Flüssigkeit abgedichtet wird, und wobei die Schnittstellenbaugruppe (32) ein Kontaktträgergehäuse (38) mit einer Gehäusewandung (38a) aufweist, an der entlang einem Stirnseitenabschnitt (38b) der Gehäusewandung (38a) die als umlaufende Dichtung ausgebildete Dichtung (36) angebracht ist, wobei das Elektronikgehäuse (20) im Aufnahmebereich (21) für die Anschlussbox (40) eine in Axialrichtung abgestufte Wandung (22) mit einem gegenüber einem ersten Wandungsbereich (24) erhöhten Auflagebereich (24a) für die Anschlussbox (40) ausbildet, **dadurch gekennzeichnet, dass** im Kontaktträgergehäuse (38) eine die Kontakte (34, 35) umgebende Gehäusewandung (38c) vorgesehen ist, die mit ihrer Stirnseite (38d) gegenüber den steckseitigen Enden der Kontakte (34, 35) in Axialrichtung (A) hervorsteht, das Elektronikgehäuse (20) oberhalb des Aufnahmeraums (21) für die Anschlussbox (40) mit einem demontierbaren Deckel (27) versehen ist und die umlaufende Dichtung (36) der Dichtungsanordnung gegen eine Innenseite (25) des Elektronikgehäuses (20) im erhöhten Auflagebereich (24a) der Wandung (22) anliegt .

2. Elektronikeinheit (1) gemäß Anspruch 1, **dadurch gekennzeichnet, dass** der Aufnahmebereich (21) für die Anschlussbox (40) oberhalb der Steckerschnittstelle (33) und oberhalb einer in einer Wandung (22) des Elektronikgehäuses (20) ausgebildeten Öffnung (23) angeordnet ist.

3. Elektronikeinheit (1) gemäß einem der Ansprüche 1 oder 2, **dadurch gekennzeichnet, dass** an dem Kontaktträgergehäuse (38), vorzugsweise integral mit dem Kontaktträgergehäuse (38) Halteelemente (39) ausgebildet sind, an oder mittels denen die Schnittstellenbaugruppe (32) auf der Leiterplatte (30) befestigt ist

4. Elektronikeinheit (1) gemäß einem der vorhergehenden Ansprüche, **dadurch gekennzeichnet, dass** eine im Bereich der Steckerschnittstelle (33) angeordnete, vorzugsweise als Vergussmasse ausgebildete Dichtung (37) als Teil der Dichtungsanordnung die Kontakte (33, 34) der Schnittstellenbaugruppe (32) zumindest teilweise umschließt und an diesen unmittelbar anliegt.

5. Elektronikeinheit (1) gemäß einem der vorhergehenden Ansprüche, ferner umfassend eine Anschlussbox (40), **dadurch gekennzeichnet, dass** die Anschlussbox (40), einen Aufnahmeraum (42) und einen Kabeldurchlass (43) für wenigstens einen mit einem Anschlusskabel versehenen Anschlusssteckverbinder (48, 49) aufweist, sowie einen mit wenigstens einer Montageöffnung (45) ausgebildeten Boden (44), durch die ein Anschlusssteckverbinder (48, 49) zur verrastenden Kontaktierung mit der Schnittstellenbaugruppe (32) hindurch gesteckt bzw. montiert werden kann.

6. Elektronikeinheit (1) gemäß einem der vorhergehenden Ansprüche, ferner umfassend eine Anschlussbox (40), **dadurch gekennzeichnet, dass** die Anschlussbox (40) ferner einen gegenüber der Anschlussbox (40) über eine Dichtung (47) abgedichteten, demontierbaren Deckel (46), vorzugsweise mit einem integrierten Lichtwellenleiter (LW) und weiter vorzugsweise mit einer integrierten Antenne (AT) aufweist.

7. Elektronikeinheit (1) gemäß einem der vorhergehenden Ansprüche, **dadurch gekennzeichnet, dass** der Deckel (27) des Elektronikgehäuses (20) mit integrierter Antenne und mit einer Statusmeldeanzeige (SM) versehen ist.

8. Elektronikeinheit (1) gemäß Anspruch 5, **dadurch gekennzeichnet, dass** der Boden (44) der Anschlussbox (40) eine zur abgestuften Wandung (22) korrespondierende Kontur aufweist.

9. Elektronikeinheit (1) gemäß einem der vorhergehenden Ansprüche, **dadurch gekennzeichnet, dass** in der Schnittstellenbaugruppe (32) ferner eine Antenne (50) und/oder eine NFC-Drossel (51) und/oder ein Lichtwellenleiter (52) angeordnet sind.

10. Elektronikeinheit (1) gemäß einem der vorhergehenden Ansprüche, **dadurch gekennzeichnet, dass** das Elektronikgehäuse (20) als topfförmiges Gehäuse mit einem umlaufenden ringförmigen Gehäuseflansch (28) ausgebildet ist.

11. Elektromotor, vorzugsweise ein Außenläufermotor mit einer Elektronikeinheit (1) gemäß einem der vorhergehenden Ansprüchen 1 bis 10.

## Claims

1. An electronics unit (1) for an electromotor, formed with an electronics housing (20), in which a control electronics (31) is arranged on a printed circuit board (30) on which an interface structural group (32) having a plug interface (33) comprising contacts (34, 35) and for inserting at least one connection plug connector (48, 49) is mounted, wherein the electronics housing (20) has a receiving area (21) into which a connection box (40) can be inserted in an authorized manner for connecting the at least one connection plug connector (48, 49), wherein further at least one sealing arrangement sealing the interface structural group (32) on the front side in an area of the plug interface (33) is provided and has a seal (36) sealing the inner of the electronics housing (20), in such a manner that the inside of the electronics housing (20) is also sealed in the non-used state of the connection box (40) against the entrance of liquid and wherein the interface structural group (32) comprises a contact carrier housing (38) having a housing wall (38a) on which the seal (36) formed as a circumferential seal is attached along a front side section (38b) of the housing wall (38a), wherein the electronics housing (20) forms in the receiving area (21) for the connection box (40) a wall (22) graduated in an axial direction with a contact area (24a) elevated opposite a first wall area (24) for the connection box (40), **characterized in that** a housing wall (38c) surrounding the contacts (34, 35) is provided in the contact carrier housing (38) and which projects with its front side (38a) in axial direction (A) opposite the plug-side ends of the contacts (34, 35), the electronics housing (20) is provided above the receiving areas (21) for the connection box (40) with a dismountable cover (27) and the circumferential seal (36) of the sealing arrangement rests against an inside (25) of the electronics housing (20) in the elevated contact area (24a) of the wall (22).

2. The electronics unit (1) according to Claim 1, **characterized in that** the receiving area (21) for the connection box (40) is arranged above the plug interface (33) and above an opening (23) formed in a wall (22) of the electronics housing (20).

3. The electronics unit (1) according to one of the claims 1 or 2, **characterized in that** holding elements (39) on or by means of which the interface structural group (32) is fastened on the printed circuit board (30), are formed at the contact carrier housing (38) preferably integral with the contact carrier housing (38).

4. The electronics unit (1) according to one of the preceding claims, **characterized in that** a seal (37) arranged in the area of the plug interface (33) and preferably designed as a cast mass at least partially surrounds the contacts (34, 35) of the interface structural group (32) as part of the sealing arrangement and rests directly on them.

5. The electronics unit (1) according to one of the preceding claims, further comprising a connection box (40), **characterized in that** the connection box (40) comprises a receiving space (42) and a cable passage (43) for at least one connection plug connector (48, 49) provided with a connection cable and comprises a bottom (44) constructed with at least one mounting opening (45) through which a connection plug connector (48, 49) can be inserted or mounted for making latching contact with the interface structural group (32).

6. The electronics unit (1) according to one of the preceding claims, further comprising a connection box (40), **characterized in that** the connection box (40) furthermore comprises a dismountable cover (46) sealed against the connection box (40) by a seal (47) preferably with an integrated optical waveguide (LW) and furthermore preferably with an integrated antenna (AT).

7. The electronic unit (1) according to one of the preceding claims, **characterized in that** the dismountable cover (27) of the electronics housing (20) is provided with an integrated antenna and with a status report display (SM).

8. The electronic unit (1) according to claim 5, **characterized in that** the bottom (44) of the connection box (40) has a contour corresponding to the graduated wall (22).

9. The electronics unit (1) according to one of the preceding claims, **characterized in that** further an antenna (50) and/or a NFC choke (51) and/or an optical wave guide (52) is arranged in the interface structural group (32).

10. The electronics unit (1) according to one of the preceding claims, **characterized in that** the electronics housing (20) is constructed as a cup-shaped housing with a circumferential annular housing flange (28).

11. An electromotor preferably an outer rotor motor with an electronics unit (1) according to one of the preceding claims 1 to 10.

## Revendications

1. Unité d'électronique (1) pour un moteur électrique, qui est réalisée avec un boîtier d'électronique (20), dans laquelle une électronique de commande (31) agencée sur un circuit imprimé (30) est agencée, sur laquelle un module d'interface (32) est fixé avec une interface à enfichage (33) présentant des contacts (34, 35) pour l'enfichage d'au moins un connecteur enfichable (48, 49), dans laquelle le boîtier d'électronique (20) présente une zone de réception (21), dans laquelle une boîte de raccordement (40) est insérable conformément à sa destination pour le raccordement du ou des connecteurs enfichables (48, 49), dans laquelle au moins un ensemble d'étanchéité est prévu en outre, qui étanchéifie le module d'interface (32) côté avant dans la zone de l'interface à enfichage (33) et présente un joint (36), qui étanchéifie l'intérieur du boîtier d'électronique (20) de telle sorte que l'intérieur du boîtier d'électronique (20) est également étanchéifié à l'état non inséré de la boîte de raccordement (40) contre l'entrée d'un fluide, et dans laquelle le module d'interface (32) présente un boîtier de support de contact (38) avec une paroi de boîtier (38a), au niveau de laquelle le joint (36) réalisé en tant que joint périphérique est monté le long d'une section côté avant (38b) de la paroi de boîtier (38a), dans laquelle le boîtier d'électronique (20) forme dans la zone de réception (21) pour la boîte de raccordement (40), une paroi étagée (22) dans la direction axiale avec une zone d'appui (24a) surélevée par rapport à une première zone de paroi (24) pour la boîte de raccordement (40), **caractérisée en ce qu'**une paroi de boîtier (38c) entourant les contacts (34, 35) est prévue dans le boîtier de support de contact (38), qui fait saillie avec son côté avant (38d) par rapport aux extrémités côté enfichable des contacts (34, 35) dans la direction axiale (A), le boîtier d'électronique (20) est doté d'un couvercle démontable (27) au-dessus de la zone de réception (21) pour la boîte de raccordement (40) et le joint périphérique (36) de l'ensemble d'étanchéité s'appuie contre une face intérieure (25) du boîtier d'électronique (20) dans une zone d'appui surélevée (24a) de la paroi (22).

2. Unité d'électronique (1) selon la revendication 1, **caractérisée en ce que** la zone de réception (21) pour la boîte de raccordement (40) est agencée au-dessus de l'interface à enfichage (33) et au-dessus d'une ouverture (23) réalisée dans une paroi (22) du boîtier d'électronique (20).

3. Unité d'électronique (1) selon l'une quelconque des revendications 1 ou 2, **caractérisée en ce que** des éléments de retenue (39) sont réalisés de préférence d'un seul tenant avec le boîtier de support de contact (38) au niveau du boîtier de support de contact (38), au niveau ou au moyen desquels le module d'interface (32) est fixé sur le circuit imprimé (30).

4. Unité d'électronique (1) selon l'une quelconque des revendications précédentes, **caractérisée en ce qu'**un joint (37) agencé dans la zone de l'interface à enfichage (33), de préférence réalisé en tant que masse de scellement entoure au moins en partie en tant que partie de l'ensemble d'étanchéité les contacts (33, 34) du module d'interface (32) et s'appuie directement sur ceux-ci.

5. Unité d'électronique (1) selon l'une quelconque des revendications précédentes, comprenant en outre une boîte de raccordement (40), **caractérisée en ce que** la boîte de raccordement (40) présente un espace de logement (42) et un passage de câble (43) pour au moins un connecteur enfichable (48, 49) doté d'un câble de raccordement, ainsi qu'un fond (44) réalisé avec au moins une ouverture de montage (45), à travers laquelle un connecteur enfichable (48, 49) peut être enfiché ou monté pour le contact par encliquetage avec le module d'interface (32).

6. Unité d'électronique (1) selon l'une quelconque des revendications précédentes, comprenant en outre une boîte de raccordement (40), **caractérisée en ce que** la boîte de raccordement (40) présente en outre un couvercle (46) démontable, étanchéifié par rapport à la boite de raccordement (40) par le biais d'un joint (47), de préférence avec une fibre optique intégrée (LW) et en outre de préférence avec une antenne intégrée (AT).

7. Unité d'électronique (1) selon l'une quelconque des revendications précédentes, **caractérisée en ce que** le couvercle (27) du boîtier d'électronique (20) est doté d'une antenne intégrée et d'un affichage de statut (SM).

8. Unité d'électronique (1) selon la revendication 5, **caractérisée en ce que** le fond (44) de la boîte de raccordement (40) présente un contour correspondant à la paroi étagée (22).

9. Unité d'électronique (1) selon l'une quelconque des revendications précédentes, **caractérisée en ce qu'**une antenne (50) et/ou un étrangleur NFC (51) et/ou une fibre optique (52) sont agencés en outre dans le module d'interface (32).

10. Unité d'électronique (1) selon l'une quelconque des revendications précédentes, **caractérisée en ce que** le boîtier d'électronique (20) est réalisé en tant que boîtier en forme de pot avec une bride de boîtier (28) annulaire périphérique.

11. Moteur électrique, de préférence moteur à rotor extérieur avec une unité d'électronique (1) selon l'une quelconque des revendications précédentes 1 à 10.
